# EUROPÄISCHE PATENTANMELDUNG

(11) **EP 1 887 634 A2**
(43) Veröffentlichungstag der Anmeldung: **13.02.2008**
(21) Anmeldenummer: 07014717.8
(22) Anmeldetag: 26.07.2007
(51) Int. Cl.: H01L 33/00

(54) **Strahlungsemittierendes Halbleiterbauelement**

(30) Priorität: 11.08.2006 DE 102006037736
(71) Anmelder: Osram Opto Semiconductors GmbH, 93049 Regensburg (DE)
(72) Erfinder: Eberhard, Franz, 93059 Regensburg (DE); Linder, Norbert, 93138 Lappersdorf (DE); Moosburger, Jürgen, 93055 Regensburg (DE); Muschaweck, Julius, 82131 Gauting (DE); Sabathil, Matthias, 93059 Regensburg (DE); Streubel, Klaus, 93164 Laaber (DE); Wirth, Ralph, 93186 Pettendorf-Adlersberg (DE); Grötsch, Stefan, 93077 Lengfeld-Bad Abbach (DE); Bergenek, Krister, 93059 Regensburg (DE)
(74) Vertreter: Epping - Hermann - Fischer

(57) **Zusammenfassung**

Die Erfindung beschreibt ein strahlungsemittierendes Bauelement (10) mit einem auf einem Halbleitermaterial basierenden Schichtenstapel (1), der eine aktive Schichtenfolge (4) zur Erzeugung von elektromagnetischer Strahlung aufweist, und einem der aktiven Schichtenfolge (4) in Abstrahlrichtung (A) nachgeordneten Filterelement (2), mittels welchem ein erster Strahlungsanteil transmittiert wird, und ein zweiter Strahlungsanteil in den Schichtenstapel (1) reflektiert wird, wobei der zweite Strahlungsanteil einem Ablenkprozess oder einem Absorptions-und Emissionsprozess unterliegt und die abgelenkte oder emittierte Strahlung auf das Filterelement (2) auftrifft.

## Beschreibung

Die Erfindung betrifft ein strahlungsemittierendes Bauelement.

Für viele Anwendungen muss das Licht einer LED in eine nachgeordnete Optik eingekoppelt werden. Diese Optik hat meist eine bestimmte numerische Apertur (NA), d.h. einen maximalen Einfallswinkel relativ zur Achse des Systems. Licht das unter größeren Winkeln zur Achse einfällt, kann in dieser Optik nicht verwendet werden und führt im ungünstigsten Fall zu Streulicht und Artefakten.

Ferner erfordern Anwendungen wie zum Beispiel die LCD-Hinterleuchtung mit LEDs oder LEDs als Lichtquellen in Projektoren häufig polarisiertes Licht. Die Emission von LEDs basiert allerdings auf spontaner Emission und ist daher unpolarisiert.

Verallgemeinert möchte man LEDs mit über die normalen optischen Eigenschaften hinausgehenden optischen Eigenschaften realisieren, ohne wesentliche Einbußen bei der Effizienz der LEDs in Kauf nehmen zu müssen.

Es ist Aufgabe der vorliegenden Erfindung ein strahlungsemittierendes Bauelement anzugeben, das in einer gewünschten Raumrichtung, bei einer gewünschten Polarisationsichtung oder Wellenlänge eine vergleichsweise hohe Leuchtdichte liefert.

Diese Aufgabe wird durch ein strahlungsemittierendes Bauelement gemäß Patentanspruch 1 gelöst.

Das erfindungsgemäße strahlungsemittierende Bauelement umfasst einen auf einem Halbleitermaterial basierenden Schichtenstapel, der eine aktive Schichtenfolge zur Erzeugung von elektromagnetischer Strahlung aufweist, und ein der aktiven Schichtenfolge in Abstrahlrichtung nachgeordnetes Filterelement, mittels welchem ein erster Strahlungsanteil transmittiert wird, und ein zweiter Strahlungsanteil in den Schichtenstapel reflektiert wird, wobei der zweite Strahlungsanteil nach der Reflexion an dem Filterelement einem Ablenkprozess oder einem Absorptions-und Emissionsprozess unterliegt und die abgelenkte oder emittierte Strahlung erneut auf das Filterelement auftrifft.

Der Ablenkprozess ist insbesondere ein Reflexionsprozess. Denkbar ist beispielsweise, dass auf einer dem Filterelement gegenüber liegenden Seite des Schichtenstapels eine Reflexionsschicht angeordnet ist, welche die auftreffende Strahlung, vorzugsweise unter einem vom Einfallswinkel verschiedenen Ausfallswinkel, in Richtung des Schichtenstapels zurückreflektiert. Zur Änderung der Winkelverteilung kann beispielsweise eine Streuschicht verwendet werden, welche die auftreffende Strahlung diffus reflektiert.

Alle vorliegend beschriebenen Bauelemente sind als eine Art Lichtkasten aufgebaut. In einem derartigen Lichtkasten läuft ein Lichtstrahl idealerweise solange umher, bis er unter einem geeigneten Winkel und/oder der geeigneten Polarisationsrichtung auf die Auskoppelfläche auftrifft und aus dem Lichtkasten auskoppeln kann. Ferner kann der Lichtstrahl in der aktiven Schichtenfolge absorbiert und mit der für die Auskopplung geeigneten Richtung, Polarisation oder Wellenlänge emittiert werden ("Photonrecycling"). Hierdurch kann folglich die Leuchtdichte erhöht werden. Lichtstrahlen, die nicht beim ersten Auftreffen auskoppeln, gehen also nicht verloren, sondern werden nach mehr als einem Auftreffvorgang ausgekoppelt.

Vorliegend kann das Filterelement ein Raumwinkelfilter, ein Polarisationsfilter oder ein Farbfilter sein, das heißt es kann richtungsselektiv, polarisationsselektiv oder wellenlängenselektiv wirken.

Vorzugsweise setzt sich der erste Strahlungsanteil aus Lichtstrahlen zusammen, die innerhalb eines ersten Raumwinkelbereichs auf die Auskoppelfläche auftreffen, während sich der zweite Strahlungsanteil aus Lichtstrahlen zusammensetzt, die innerhalb eines zweiten zum ersten Raumwinkelbereich verschiedenen, vorzugsweise komplementären, Raumwinkelbereich auftreffen. Ferner kann der erste Strahlungsanteil linear polarisierte Lichtstrahlen einer ersten Polarisationsrichtung und der zweite Strahlungsanteil linear polarisierte Lichtstrahlen mit einer zweiten Polarisationsrichtung senkrecht zur ersten Polarisationsrichtung aufweisen. Schließlich kann der erste Strahlungsanteil Lichtstrahlen mit Wellenlängen aufweisen, die innerhalb eines Wellenlängenbereichs liegen, der mit einem Wellenlängenbereich für die Lichtstrahlen des zweiten Strahlungsanteils im Wesentlichen nicht überlappt.

Gemäß einer bevorzugten Variante ist das Filterelement ein Raumwinkelfilter. Der Raumwinkelfilter kann beispielsweise ein dielektrischer Bandpassfilter oder ein photonischer Kristall sein oder verschiedenartig geformte Strukturelemente aufweisen, die den Abstrahlwinkel einschränken.

Insbesondere kann das Filterelement eine ebene Schicht aufweisen, die ein Material mit einem Brechungsindex enthält, der kleiner ist als der Brechungsindex des Halbleitermaterials des Schichtenstapels.

Gemäß einer bevorzugten Ausführungsform weist das Filterelement mindestens eine ebene Schicht auf, die ein strahlungsdurchlässiges Material enthält.
Vorzugsweise kommen folgende Materialien für das Filterelement beziehungsweise die mindestens eine Schicht in Frage: Siliziumoxid, Siliziumnitrid, Siliziumoxinitrid, Aluminiumoxid, Titanoxid, Tantaloxid, ein Glasmaterial oder ein TCO (Transparent Conductive Oxide). TCOs sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Vorzugsweise wird für das Filterelement ein Material verwendet, das für eine kontrollierte Abscheidung geeignet ist, so dass beispielsweise Unebenheiten, welche die optische Wirkung des Filterelements beeinträchtigen können, weitestgehend verhindert werden.

Ist das Filterelement als dielektrischer Bandpassfilter ausgeführt, so weist es gemäß einer vorteilhaften Ausgestaltung mindestens zwei dielektrische Schichten mit unterschiedlichem Brechungsindex auf. Insbesondere kann der Bandpassfilter eine erste Schicht, die Titannitrid enthält, und eine zweite Schicht, die ein Siliziumoxid oder Titanoxid enthält, aufweisen.

Vorzugsweise ist das als dielektrischer Bandpassfilter ausgeführte Filterelement derart aufgebaut, dass sich die Strahlungsverteilung für Strahlen, die kleine Winkel, das sind vorzugsweise Winkel zwischen 0° und etwa 40°, mit einer Oberflächennormalen des Filterelements einschließen, innerhalb eines Passbandes des Filterelements befindet. Dies hat zur Folge, dass diese Lichtstrahlen mit großer Wahrscheinlichkeit transmittiert werden. Die Wahrscheinlichkeit, dass Lichtstrahlen reflektiert werden, nimmt umso mehr zu, je größer der Winkel wird, den die Lichtstrahlen mit der Oberflächennormalen einschließen.

Der dielektrische Bandpassfilter gemäß der Erfindung muss nicht so präzise und gut, und damit auch nicht so teuer sein wie zum Beispiel bei Linsenvergütungen. Der dielektrische Filter kann auf ein dünnes Glas- oder Kunststoffplättchen aufgebracht und so in ohnehin vorgesehene Bauformen integriert werden. Alternativ kann der dielektrische Filter direkt auf dem Schichtenstapel aufgebracht sein.

Ein Vorteil des dielektrischen Bandpassfilters liegt darin, dass Licht unter hohen Winkeln nicht mehr austritt. So lässt sich etwa eine weitere Bündelung ohne Leuchtdichte- und Effizienzverlust durch eine einfache Sammellinse in relativ großem Abstand von der LED realisieren, während diffuse Strahler schwieriger zu realisierende Optiken hierfür benötigen.

Gemäß einer weiteren Ausgestaltung des Filterelements weist dieses Strukturelemente auf. Die Strukturelemente sind vorzugsweise derart geformt, dass durch sie eine raumwinkelabhängige Filterung von Strahlung möglich ist. Beispielsweise können die Strukturelemente in der Abstrahlrichtung schmaler werden. Die Strukturelemente können eine kegelartige, pyramidenartige oder prismenartige Gestalt aufweisen oder gleich einem inversen CPC (Compound Parabolic Concentrator) ausgebildet sein. Die Strukturen bestehen beispielsweise aus langgestreckten, "bergrückenartigen" Elementen zur Erzielung einer direktionalen Abstrahlcharakteristik in nur einer Richtung. Allgemein können die Strukturelemente nach oben hin spitz zulaufende Elemente mit beliebiger Grundflächenform für Direktionalität in allen Raumrichtungen sein.

Gemäß einer weiteren Variante werden die Strukturelemente in der Abstrahlrichtung breiter. Eine möglichst dichte Anordnung langgestreckter oder kreisförmiger Strukturelemente, die sich nach oben öffnen ("Taper"), ist bei dieser Variante besonders geeignet. In bevorzugten Ausführungsformen ist der Basiswinkel insbesondere größer als 40°, bevorzugt größer als 60°, besonders bevorzugt größer als 70°. Das Verhältnis zwischen oberer und unterer Öffnung bestimmt die Direktionalität und ist in bevorzugten Ausführungsformen insbesondere größer als 2, bevorzugt größer als 4, besonders bevorzugt größer als 6. Die taperförmigen Strukturelemente können entweder in das Halbleitermaterial des Schichtenstapels geätzt werden oder in einer separaten Schicht aus anderem Material, das vorzugsweise einen so hohen Brechnungsindex wie das Halbleitermaterial aufweist, hergestellt werden. Die Oberflächen zwischen den taperförmigen Strukturelementen können verspiegelt sein, ebenso die Seitenwände der Strukturelemente.

Die Strukturelemente werden also gemäß einer Variante auf dem Schichtenstapel erzeugt. Dies kann beispielsweise durch Strukturierung des Schichtenstapels erfolgen, so dass die Strukturelemente ebenfalls aus einem Halbleitermaterial gebildet sind, oder durch Strukturierung einer auf dem Schichtenstapel aufgebrachten Schicht beziehungsweise durch strukturiertes Aufbringen der Strukturelemente, so dass die Strukturelemente ein von einem Halbleitermaterial verschiedenes Material wie beispielsweise ein Siliziumoxinitrid, Siliziumnitrid, Aluminiumoxid, Titanoxid oder Tantaloxid enthalten.

Eine weitere Variante sieht ein separates Filterelement mit vorgefertigten Strukturelementen vor. Insbesondere kann das Filterelement eine Folie sein, die Strukturelemente aufweist. Eine derartige Folie kann eine allgemein bekannte Brightness Enhancement Folie (BEF) sein, die beispielsweise linienförmig angeordnete Prismenstrukturen aufweist. Licht, das von der Unterseite in die Folie eingekoppelt wird, kann teilweise transmittiert und teilweise reflektiert werden. Der transmittierte Strahlungsanteil ist hierbei aufgrund der Wirkung der BEF in einer Raumrichtung auf einen engeren Öffnungswinkel eingeschränkt als dies ohne BEF der Fall wäre. Mittels eines gekreuzten Paares von BEFs kann diese Wirkung auch für zwei Raumrichtungen erzielt werden. Da die Folienmaterialien vergleichsweise wenig absorbieren, wird die nicht transmittierte Strahlung nach dem Energieerhaltungssatz reflektiert, so dass die Folie (bzw. ein gekreuztes Paar) in Summe also einen Filter darstellt, der Strahlen in einem engen Winkel um die Normale transmittiert und den Rest der Strahlung reflektiert. Es ist zum Beispiel auf diese Weise möglich, die aus dem Bauelement emittiere Strahlung auf einen Winkel von ca. +/- 25° relativ zur Oberflächennormalen des Filterelements einzuschränken.

Zwischen dem Schichtenstapel und dem Filterelement, das Strukturelemente aufweist, kann eine strahlungsdurchlässige Schicht angeordnet sein, die insbesondere Glas, Spin-on Glas, Epoxidharz, Silikon, PMMA (Polymethylmethacrylat), ein transparentes organisches Material, Photolack, Siliziumoxid oder Siliziumoxinitrid enthält. Hierbei sind für die Strukturelemente Materialien wie Siliziumoxinitrid, Siliziumnitrid, Siliziumoxid, Aluminiumoxid, Titanoxid oder Tantaloxid besonders geeignet.

Ferner kann zwischen dem Schichtenstapel und dem Filterelement ein luftgefüllter Zwischenraum sein. In diesem Fall werden für die Strukturelemente vorzugsweise folgende Materialien verwendet: Glas, Spin-on Glas, Epoxidharz, Silikon, PMMA, transparentes organisches Material, Photolack, Siliziumoxinitrid, Siliziumnitrid, Siliziumoxid, Aluminiumoxid, Titanoxid oder Tantaloxid.

Die Größe der Strukturelemente kann stark variieren. Die Strukturelemente können Größen von etwa 100 nm, bevorzugt größer als 1 µm, annehmen, können sich aber auch über die gesamte Chipgröße erstrecken.

Bevorzugterweise sind die Strukturelemente auf der Oberfläche des Schichtenstapels regelmäßig angeordnet. Desweiteren sind die Strukturelemente besonders bevorzugt entsprechend einem zweidimensionalen Gitter angeordnet.

Gemäß einer bevorzugten Ausführungsform weist das Filterelement einen photonischen Kristall auf. Der photonische Kristall kann als Raumwinkelfilter oder als Polarisationsfilter dienen.

Gemäß einer weiteren bevorzugten Variante der Erfindung ist das Filterelement ein Polarisationsfilter. Die Wirkung des als Polarisationsfilter ausgebildeten Filterelements ist vorzugsweise dergestalt, dass der erste Strahlungsanteil linear polarisierte Lichtstrahlen einer ersten Polarisationsrichtung und der zweite Strahlungsanteil linear polarisierte Lichtstrahlen einer zweiten Polarisationsrichtung, die senkrecht zur ersten Polarisationsrichtung ist, aufweisen.

Der Polarisationsfilter lässt also Licht mit einer ersten Polarisationsrichtung durch, alles andere Licht wird in den Chip zurückreflektiert. Dort wird es zumindest teilweise in der aktiven Schichtenfolge absorbiert und, entsprechend der internen Quanteneffizienz, wieder mit einer neuen Polarisationsrichtung emittiert. Die Absorption und Reemission von Strahlung in der aktiven Schichtenfolge wird auch als "Photonrecycling" bezeichnet. Nicht absorbiertes Licht kann an der Grenzfläche zu einem Trägersubstrat oder, bei transparenten Trägersubstraten, an der Substratrückseite reflektiert werden. Besonders vorteilhaft hierfür sind Dünnfilm-LEDs mit einem integrierten Metallspiegel. Das reflektierte Licht läuft wieder durch die aktive Schichtenfolge, wo es entweder absorbiert wird oder wieder auf das reflektierende Polarisationsfilter trifft. Bei einer internen Quanteneffizienz von 100 % würde in einer solchen Anordnung das Licht solange in der LED reflektiert, absorbiert und re-emittiert werden, bis es mit der gewünschten Polarisationsrichtung den Chip beziehungsweise das strahlungsemittierende Bauelement verlassen kann.

Gemäß einer Ausführungsform der Erfindung enthält das Filterelement mindestens ein doppelbrechendes Material. Dieses zeichnet sich dadurch aus, dass es optisch anisotrop ist, das heißt, dass die optischen Eigenschaften nicht in allen Raumrichtungen gleich sind. Das Filterelement weist so verschiedene Brechungsindizes für verschiedene Polarisationsrichtungen und Raumrichtungen auf. Dies hat zur Folge, dass Lichtstrahlen in zwei Teilstrahlen verschiedener Raumrichtung und Polarisationsrichtung aufgespalten werden. Eine Trennung der beiden Teilstrahlen führt zu dem ersten und dem zweiten Strahlungsanteil.

Gemäß einer weiteren Ausführungsform der Erfindung weist das Filterelement mindestens eine erste doppelbrechende Schicht mit einem ersten Brechungsindex n1 und einem zweiten Brechungsindex n und mindestens eine zweite doppelbrechende Schicht mit einem dritten Brechungsindex n2 und dem zweiten Brechungsindex n auf. Vorzugsweise ist die zweite Schicht der ersten Schicht in Abstrahlrichtung nachgeordnet. So variiert bei dem einen Teilstrahl der Brechungsindex beim Passieren der beiden Schichten, während bei dem anderen Teilstrahl der Brechungsindex konstant bleibt. Durch geeignete Wahl von n1 und n2 kann der Teilstrahl reflektiert werden.

Bei einer bevorzugten Variante weisen die erste und zweite Schicht eine optische Dicke von λ/4 auf. Hierbei kann beispielsweise durch destruktive Interferenz in Abstrahlrichtung die Transmission des einen Teilstrahls verringert werden, während der andere Teilstrahl, für welchen am Übergang zwischen der ersten und der zweiten Schicht kein Brechungsindexsprung auftritt, das Filterelement nahezu ungeschwächt passiert.

Derartige doppelbrechende Schichten können beispielsweise durch Verspannung der Schichten hergestellt werden. Insbesondere können die Schichten in eine bestimmte Richtung gezogen werden. Bevorzugterweise enthalten die Schichten ein Kunststoffmaterial. Besonders bevorzugt ist das Filterelement eine Kunststofffolie, die eine Folge doppelbrechender Schichten mit alternierendem Brechungsindex für eine Polarisationrichtung und Raumrichtung aufweist.

Ferner kann bei dem Filterelement gemäß der Erfindung eine polarisationsabhängige Filterung dadurch erzielt werden, dass das Filterelement ein Metallgitter aufweist. Vorzugsweise besteht das Metallgitter aus Metallstreifen, die zu einer Kante des Schichtenstapels parallel verlaufen. Lichtstrahlen, die eine Polarisationsrichtung parallel zu den Metallstreifen aufweisen, werden reflektiert, während Lichtstrahlen, die eine Polarisationsrichtung senkrecht zu den Metallstreifen aufweisen, transmittiert werden.

Hierbei kann der Schichtenstapel derart strukturiert sein, dass die Metallstreifen auf Erhebungen des Schichtenstapels verlaufen. Die Erhebungen sind als Streuzentren zur Erhöhung der Strahlungsauskopplung gedacht.

Die Metallstreifen sind vorzugsweise in einem Abstand voneinander angeordnet, der kleiner ist als die Wellenlänge der in der aktiven Schichtenfolge erzeugten Strahlung. Die Breite der Metallstreifen sollte einen Bruchteil dieses Abstands ausmachen. Derart kleine Strukturen können beispielsweise durch lithographische Techniken oder ein Imprint-Verfahren hergestellt werden.

Bei allen genannten Ausführungsformen kann eine Reflexionsschicht vorgesehen sein. Insbesondere ist die Reflexionsschicht auf einer dem Filterelement gegenüber liegenden Seite der aktiven Schichtenfolge angeordnet. Beispielsweise kann die Reflexionsschicht auf einem Trägersubstrat aufgebracht sein. Typischerweise enthält die Reflexionsschicht ein Metall.

Ferner kann bei allen genannten Ausführungsformen eine Streuschicht vorgesehen sein. Diese kann beispielsweise zwischen der aktiven Schichtenfolge und der Reflexionsschicht oder zwischen der aktiven Schichtenfolge und dem Filterelement angeordnet sein. Als Streuschicht kann eine aufgeraute Halbleiteroberfläche, eine regelmäßig strukturierte Halbleiteroberfläche, zum Beispiel mit photonischen Kristallstrukturen oder eine Schicht mit geometrischen Strukturen, das heißt Strukturen mit Größen oberhalb der Wellenlänge (zum Beispiel Mikroprismen), verwendet werden.

Weiterhin kann dem Schichtenstapel bei allen beschriebenen Varianten des Filterelements in Abstrahlrichtung ein optisches Element nachgeordnet sein, wobei das Filterelement vorzugsweise auf einer Strahlungsdurchtrittsfläche des optischen Elements angeordnet ist, das heißt das Filterelement kann sich in Abstrahlrichtung vor oder nach dem optischen Element befinden. Insbesondere ist das optische Element ein Reflektor und/oder Konzentrator, etwa ein CPC (Compound Parabolic Concentrator), ein CHC (Compound Hyperbolic Concentrator) oder CEC (Compound Elliptic Concentrator).

Bei einer vorteilhaften Ausgestaltung wird das Licht aus dem Schichtenstapel in das optische Element, zum Beispiel einen optischen Konzentrator, eingekoppelt. Der Konzentrator wird so ausgelegt, dass das Licht möglichst verlustfrei geführt wird. Am Ausgang des Konzentrators wird ein Filterelement angebracht, das die gewünschte Funktionalität aufweist. Zum Beispiel kann zur Erhöhung der Direktionalität eine BEF verwendet werden, unter Umständen kann aber auch der Konzentrator selbst so ausgelegt werden, dass er die gewünschte Richtwirkung aufweist und somit als Filterelement dient.

Wenn man dagegen polarisiertes Licht erzeugen will, kann am Ausgang des Konzentrators ein Polarisationsfilter angebracht sein. Weiterhin können z.B. optische Gitter, Spalte, oder holographische Elemente verwendet werden. Das Filterelement muss so beschaffen sein, dass es das nicht-transmittierte Licht weitgehend verlustfrei in den Konzentrator zurückkoppelt. Der Konzentrator wiederum leitet das zurückgekoppelte Licht möglichst verlustfrei auf die LED beziehungsweise den Schichtenstapel zurück, wo es nach Durchlaufen der aktiven Schichtenfolge und Reflexion an der rückseitigen Reflexionsschicht wieder in das optische Element, hier den Konzentrator, eingekoppelt wird.

Eine Konzentratoroptik kann für einen Polarisationsfilter vorteilhaft sein, wenn sie vor dem Polarisationsfilter angeordnet ist, da sie die Strahlung am Ausgang auf einen Winkelbereich konzentriert, in welchem der Polaristaionsfilter besonders wirksam ist.

Anstelle des optischen Elements kann das Filterelement, beispielsweise die Filterfolie, auch möglichst nahe an die LED beziehungsweise den Schichtenstapel herangebracht werden, so dass das nicht-transmittierte Licht weitgehend vollständig auf die LED beziehungsweise den Schichtenstapel zurückreflektiert wird.

Gemäß einer bevorzugten Variante ist das optische Element ein Reflektor, der den LED-Chip umschließt und am Auskoppelende mit dem Filterelement abgeschlossen wird.

Insbesondere ist der Schichtenstapel vorliegend in Dünnfilmtechnik hergestellt und zeichnet sich vorzugsweise durch mindestens eines der folgenden charakteristischen Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert'scher Oberflächenstrahler und eignet sich von daher besonders gut für die Anwendung in einem Scheinwerfer.

Wie bereits erwähnt liegt allen beschriebenen Ausführungsformen das Prinzip des Lichtkastens zugrunde. Lichstrahlen, die nicht ausgekoppelt werden, können so im Lichtkasten umlaufen und in einem zweiten oder x-ten Anlauf auskoppeln. Vorteilhaft ist hierbei ein LED-Chip mit möglichst wenig interner Absorption, möglichst wenig Auskopplung über die Seitenflanken und einem unterhalb der aktiven Zone hochreflektiven Spiegel. Des Weiteren ist ein Streumechanismus im LED-Chip wichtig, der den Lichtstrahlen neue Winkel für den "zweiten Versuch" gibt. Alle diese Eigenschaften werden insbesondere von Dünnfilm-LED Chips erfüllt. Es ist aber auch denkbar, andere Chips zu verwenden, z.B. TS-LEDs (Transparent Substrate LEDs).
Mit Vorteil wird der Schichtenstapel an den Seitenflanken verspiegelt, da hierdurch der Teil des Lichts, der durch die Seitenflanken austritt, verringert ist.

Weitere Merkmale, Vorteile und Weiterbildungen der Erfindung ergeben sich aus den nachfolgend in Verbindung mit den Figuren 1 bis 15 erläuterten Ausführungsbeispielen.

Es zeigen:
Figur 1 eine schematische Querschnittsansicht eines ersten Ausführungsbeispiels eines erfindungsgemäßen strahlungsemittierenden Bauelements,
Figuren 2a und 2b jeweils eine Draufsicht zweier verschiedener Ausführungsbeispiele eines erfindungsgemäßen Filterelements und Figur 2c eine Querschnittsansicht der beiden in den Figuren 2a und 2b gezeigten Ausführungsbeispiele des Filterelements,
Figur 3 eine Querschnittsansicht eines zweiten Ausführungsbeispiels eines erfindungsgemäßen strahlungsemittierenden Bauelements,
Figur 4 eine schematische Querschnittsansicht eines dritten Ausführungsbeispiels eines erfindungsgemäßen strahlungsemittierenden Bauelements,
Figur 5 eine schematische Querschnittsansicht eines vierten Ausführungsbeispiels eines erfindungsgemäßen strahlungsemittierenden Bauelements,
Figur 6 ein erstes Schaubild darstellend Reflexionsspektren eines erfindungsgemäßen Raumwinkelfilters und ein zweites Schaubild darstellend die spektrale Verteilung der erzeugten Strahlung,
Figur 7a eine schematische Querschnittsansicht eines fünften Ausführungsbeispiels eines erfindungsgemäßen strahlungsemittierenden Bauelements und Figur 7b eine perspektivische Ansicht des in Figur 7a gezeigten Filterelements,
Figuren 8a bis 8d eine Draufsicht auf verschiedene Ausführungsbeispiele eines Filterelements und Figur 8e eine Querschnittsansicht eines sechsten Ausführungsbeispiels eines erfindungsgemäßen strahlungsemittierenden Bauelements mit einem Filterelement gemäß Figur 8a oder Figur 8d,
Figur 9a eine schematische Querschnittsansicht eines siebten Ausführungsbeispiels eines erfindungsgemäßen strahlungsemittierenden Bauelements, Figur 9b ein Schaubild u.a. darstellend Transmissionsspektren des in Figur 9a gezeigten Bauelements und Figur 9c ein Ausschnitt aus dem in Figur 9a gezeigten Filterelement,
Figur 10 eine schematische Querschnittsansicht eines achten Ausführungsbeispiels eines erfindungsgemäßen strahlungsemittierenden Bauelements,
Figur 11 eine schematische Querschnittsansicht eines neunten Ausführungsbeispiels eines erfindungsgemäßen strahlungsemittierenden Bauelements,
Figur 12 eine schematische Querschnittsansicht eines zehnten Ausführungsbeispiels eines erfindungsgemäßen strahlungsemittierenden Bauelements,
Figur 13 eine schematische Querschnittsansicht eines elften Ausführungsbeispiels eines erfindungsgemäßen strahlungsemittierenden Bauelements,
Figur 14 eine schematische Querschnittsansicht eines zwölften Ausführungsbeispiels eines erfindungsgemäßen strahlungsemittierenden Bauelements,
Figur 15 eine schematische Querschnittsansicht eines dreizehnten Ausführungsbeispiels eines erfindungsgemäßen strahlungsemittierenden Bauelements.
Figur 16 eine schematische Querschnittsansicht eines vierzehnten Ausführungsbeispiels eines erfindungsgemäßen strahlungsemittierenden Bauelements,
Figur 17 eine schematische Querschnittsansicht eines fünfzehnten Ausführungsbeispiels eines erfindungsgemäßen strahlungsemittierenden Bauelements,
Figur 18 eine schematische Querschnittsansicht eines sechzehnten Ausführungsbeispiels eines erfindungsgemäßen strahlungsemittierenden Bauelements,
Figur 19 eine schematische Querschnittsansicht eines siebzehnten Ausführungsbeispiels eines erfindungsgemäßen strahlungsemittierenden Bauelements,
Figur 20 eine schematische Querschnittsansicht eines achzehnten Ausführungsbeispiels eines erfindungsgemäßen strahlungsemittierenden Bauelements.

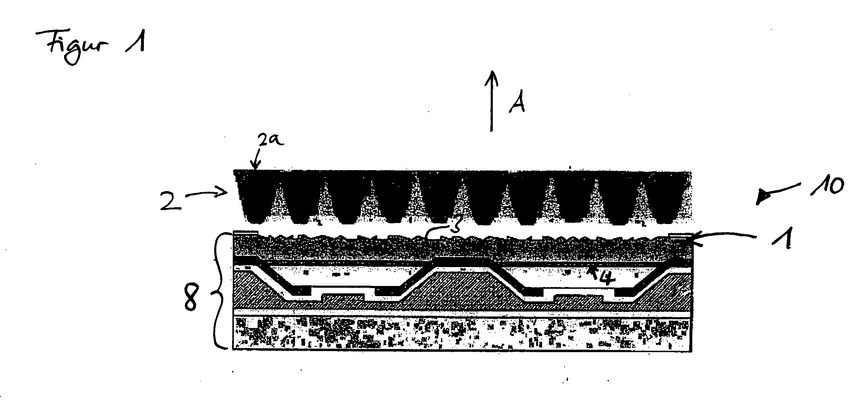

Das in Figur 1 dargestellte strahlungsemittierende Bauelement 10 umfasst einen Halbleiterchip 8 und ein Filterelement 2. Der Halbleiterchip 8 weist einen auf einem Halbleitermaterial basierenden Schichtenstapel 1 mit einer aktiven Schichtenfolge 4 und weitere nicht näher bezeichnete Elemente, beispielsweise zur Kontaktierung des Halbleiterchips 8, auf. Insbesondere ist der Halbleiterchip 8 ein Dünnfilm-Chip. Die aktive Schichtenfolge 4 ist zur Erzeugung von elektromagnetischer Strahlung vorgesehen und weist im einfachsten Falle eine p-dotierte und eine n-dotierte Schicht auf. Das Filterelement 2 ist der aktiven Schichtenfolge 4 in Abstrahlrichtung A nachgeordnet.

Das Filterelement 2 kann direkt auf dem Schichtenstapel 1 aufgebracht sein. Beispielsweise kann das Filterelement 2 vorgefertigt sein und bereits Strukturelemente 2a aufweisen. Das vorgefertigte Filterelement 2 kann so auf den Schichtenstapel 1 aufgeklebt werden. Ferner kann das Filterelement 2 zum Schichtenstapel 1 beabstandet angeordnet sein, so dass beispielsweise zwischen dem Schichtenstapel 1 und dem Filterelement 2 ein Luftspalt vorhanden ist.

Ein erster Strahlungsanteil, der in Bezug auf die Abstrahlrichtung A in einem achsennahen Winkel auf das Filterelement 2 auftrifft, wird mittels des Filterelements 2 transmittiert, während ein zweiter Strahlungsanteil, der unter einem flachen Winkel auftrifft, auf die Chipoberfläche 3 zurückgeworfen wird. Dort wird die Strahlung größtenteils in den Schichtenstapel 1 eingekoppelt. Die Chipoberfläche 3 kann strukturiert, beispielsweise aufgerauht, sein, so dass ein Teil der Strahlung zurückgestreut wird. Ferner absorbiert die aktive Schichtenfolge 4 Strahlung und emittiert wiederum Strahlung gemäß ihrer internen Effizienz.

Alle diese Mechanismen führen zu einer Veränderung des Winkels der zurückreflektierten Lichtstrahlen relativ zur Abstrahlrichtung A, so dass bei einem nachfolgenden Auftreffen der Strahlung auf das Filterelement 2 ein weiterer Strahlungsanteil das Filterelement 2 durchstrahlen kann.

Das Filterelement 2 enthält vorzugsweise ein für die von der aktiven Schichtenfolge 4 erzeugte Strahlung durchlässiges Material, dessen Brechungsindex geringer ist als der Brechungsindex des für die aktive Schichtenfolge 4 verwendeten Materials. Beispielsweise beträgt der Brechungsindex 1.5.

Das Abstrahlprofil kann bei dem dargestellten Beispiel in x- und y-Richtung (z-Richtung = optische Achse = Abstrahlrichtung A) durch die Ausbildung des Filterelements 2 in Form eines Arrays von inversen CPCs (Compound Parabolic Concentrators) eingeschränkt werden. Das in Figur 1 dargestellte Filterelement 2 ist also ein Raumwinkelfilter.

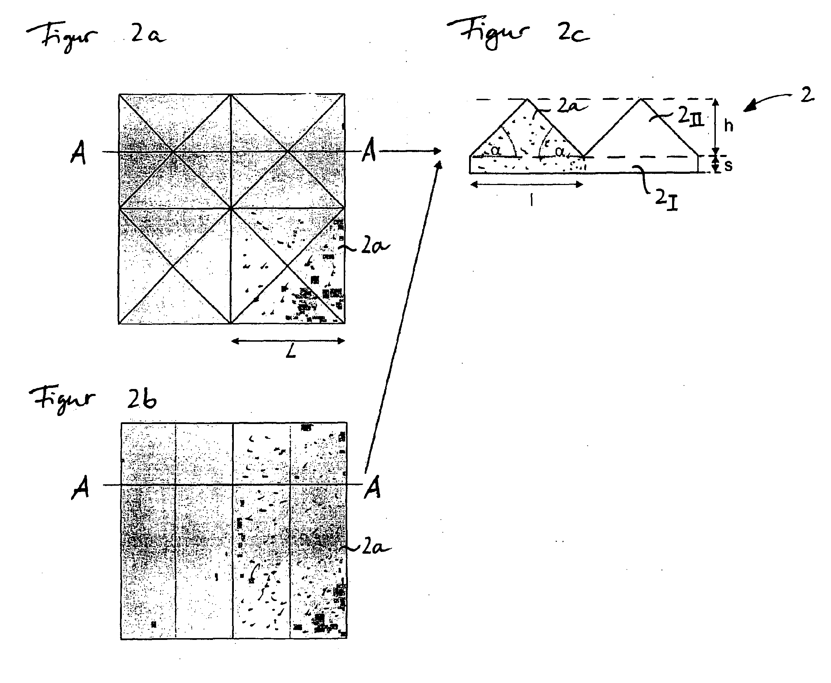

In den Figuren 2a und 2b sind weitere für ein erfindungsgemäßes Filterelement geeignete Strukturelemente 2a in Aufsicht und in Figur 2c im Querschnitt entlang der Linie AA dargestellt. In Figur 2a sind quadratische pyramidenförmige Strukturelemente 2a und in Figur 2b langgestreckte, bergrückenförmige oder prismenförmige Strukturelemente 2a dargestellt. Wie aus Figur 2c hervorgeht, weisen die Strukturelemente 2a eine Kantenlänge 1 auf, die minimal wenige 100nm, aber auch mehr als 1 µm betragen kann und im Extremfall der Kantenlänge des Chips entsprechen kann. Ferner nimmt ein Basiswinkel α der Strukturelemente 2a insbesondere Werte zwischen 30° und 60°, vorzugsweise zwischen 40° und 50°, an.

Das Filterelement 2 setzt sich aus einer ersten Teilschicht 2_{I} und einer zweiten Teilschicht 2_{II} zusammen, wobei die zweite Teilschicht 2_{II} strukturiert ist. Vorzugsweise ist der Brechungsindex n2 der zweiten Teilschicht 2_{II} größer oder gleich groß wie der Brechungsindex n1 der ersten Teilschicht 2_{I}.

Hierbei kommen folgende Materialien für die erste Teilschicht 2_{I} in Frage: Glas/Spin-on Glas, Epoxidharz, Silikon, PMMA, ein transparentes organisches Material, Photolack, ein Siliziumoxid, ein Siliziumoxinitrid. Für die zweite Teilschicht 2_{II} können dann folgende Materialien verwendet werden: ein Siliziumnitird, Siliziumoxinitrid, Aluminiumoxid, Titanoxid, Tantaloxid.

Besteht die erste Teilschicht 2_{I} aus Luft, so sind folgende Materialien für die zweite Teilschicht 2_{II} geeignet: Glas/Spin-on Glas, Epoxidharz, Silikon, PMMA, transparentes organisches Material, Photolack, Siliziumoxid, Siliziumoxinitrid, Siliziumnitird, Aluminiumoxid, Titanoxid, Tantaloxid.

Das Filterelement 2 kann bereits vorgefertigt auf den Schichtenstapel aufgebracht werden. Beispielsweise weist die bereits erwähnte BEF einen wie in Figur 2c dargestellten Aufbau auf und kann direkt auf den Schichtenstapel aufgebracht werden. Alternativ kann auf den Schichtenstapel zunächst die erste Teilschicht 2_{I} und dann die unstrukturierte zweite Teilschicht 2_{II} aufgebracht werden, die beispielsweise BCB (Benzocyclobuten) enthält und zum Beispiel durch Prägen strukturiert werden kann, so dass die Strukturelemente 2a ausgebildet werden.

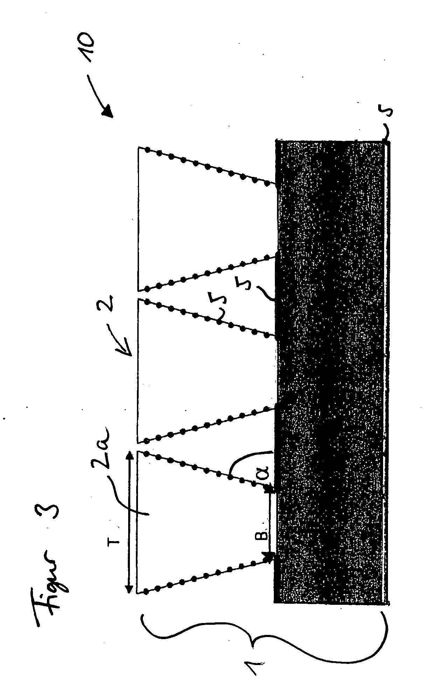

Das in Figur 3 gezeigte Filterelement 2 weist Strukturelemente 2a in Form von Tapern auf. Die Strukturelemente 2a werden nach oben breiter, das heißt dass eine oberer Durchmesser T der Strukturelemente 2a größer ist als ein unterer Durchmesser B. Insbesondere bestimmt das Verhältnis T:B die Direktionalität des Filterelements 2 und ist bevorzugterweise > 2, besonders bevorzugt > 4, weiter besonders bevorzugt > 6. Für den Basiswinkel α sind bevorzugte Werte > 40°, insbesondere > 60°, besonders bevorzugt > 70°.

Die Strukturelemente 2a sind aus dem Schichtenstapel 1 herausgeätzt, das heißt die Strukturelemente 2a enthalten ein Halbleitermaterial. An Seitenflächen sind die Strukturelemente 2a mit einer Reflexionsschicht 5 versehen. Ferner weist der Schichtenstapel 5 auf der Rückseite eine Reflexionsschicht 5 auf. Eine weitere Reflexionsschicht 5 befindet sich zwischen den einzelnen Strukturelementen 2a.

Die Strukturelemente 2a können auch aus einem anderen Material wie Glas/Spin-on Glas, Epoxidharz, Silikon, PMMA, einem transparenten organischen Material, Photolack, Siliziumoxid, Siliziumoxinitrid, Siliziumnitird, Aluminiumoxid, Titanoxid oder Tantaloxid gebildet sein. Vorzugsweise wird ein Material mit hohem Brechungsindex, das heißt im Bereich des Halbleitermaterials, gewählt. Beispielsweise sind die Strukturelemente 2a auf einer Schicht des Schichtenstapels angeordnet, die insbesondere eine Streuschicht ist.

Die Strukturelemente 2a können einen unteren Durchmesser B aufweisen, der minimal wenige 100nm, aber auch mehr als 1 µm betragen kann und im Extremfall der Kantenlänge des Chips entsprechen kann.

Während bei einem wie in den Figuren 1 bis 3 dargestellten Filterelement die raumwinkelabhängige Filterung mittels geeignet geformter Strukturelemente erfolgt, zeigt Figur 4 ein Bauelement 10 mit einem Filterelement 2, bei welchem die raumwinkelabhängige Filterung durch Ausnutzung von Interferenzeffekten erfolgt.

Das Filterelement 2 weist mindestens eine erste dielektrische Schicht 20a und mindestens eine zweite dielektrische Schicht 20b auf. Durch die gestrichelte Schicht 20n sei angedeutet, dass das Filterelement 2 eine Mehrzahl von n Schichten aufweisen kann. Die beiden Schichten 20a und 20b enthalten Materialien mit verschiedenen Brechungsindizes. Vorzugsweise weist das Halbleitermaterial des Schichtenstapels 1 einen größeren Brechungsindex auf als die dielektrischen Schichten 20a und 20b. Insbesondere kann die erste dielektrische Schicht 20a Titannitrid und die zweite dielektrische Schicht 20b Siliziumoxid enthalten. Ein für das Filterelement 2 charakteristisches Reflexionsspektrum ist in Figur 6 dargestellt und wird nachfolgend näher erläutert.

Während sich das Filterelement 2 auf der Vorderseite des strahlungsemittierenden Bauelements 10 befindet, kann auf der Rückseite eine Reflexionsschicht und/oder ein Träger angeordnet sein, was durch das gestrichelte Element 100 angedeutet ist. Ein deratiges Element 100 ist dafür vorgesehen, die auftreffende Strahlung, die sich zumindest teilweise aus dem vom Filterelement 2 zurückreflektierten Strahlungsanteil zusammensetzt, wiederum in Richtung der Vorderseite umzulenken, vorzugsweise unter einem anderen Winkel, so dass der Lichtstrahl aus dem Bauelement auskoppeln kann.

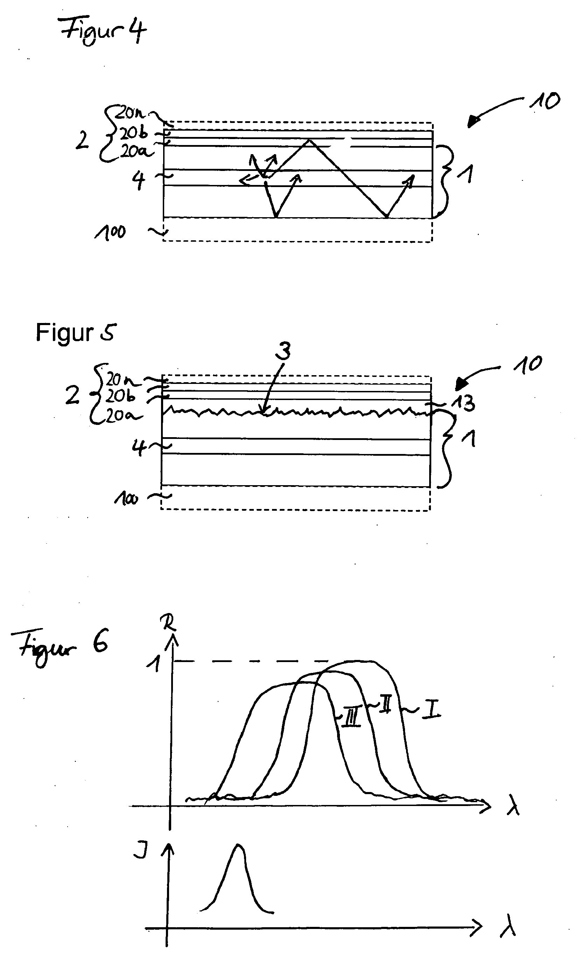

In Figur 5 ist ein strahlungsemittierendes Bauelement 10 gezeigt, das sich von dem in Figur 4 dargestellten Bauelement hauptsächlich dadurch unterscheidet, dass es einen Schichtenstapel 1 mit aufgerauter Oberfläche 3 aufweist. Die aufgeraute Oberfläche 3 weist eine Vielzahl von Streuzentren auf, welche eine Änderung der Winkelverteilung ermöglichen. Vorteilhafterweise kann hierdurch die Strahlungsauskopplung erhöht werden.

Da das als dielektrischer Bandpassfilter ausgelegte Filterelement 2 Schichten mit homogener Schichtdicke aufweisen sollte, ist die aufgeraute Oberfläche 3 zum direkten Aufbringen des Filterelements 2 ungeeignet. Daher ist auf dem Schichtenstapel 1 eine Planarisierungsschicht 13 angeordnet, die einen ebenen Untergrund für das Filterelement 2 bildet. Die Planarisierungsschicht 13 enthält vorzugsweise ein strahlungsdurchlässiges Material, beispielsweise Siliziumoxid oder Spin-on Glas.

Vorteilhafterweise nimmt der Brechungsindex vom Schichtenstapel 1 bis zum Filterelement 2 ab.

Es sei angemerkt, dass die im Zusammenhang mit den Figuren 4 und 5 beschriebenen Filterelemente beispielsweise auch auf einem Plättchen aufgebracht sein können und mittels dieses Plättchens an einem Gehäuse (nicht dargestellt) des Bauelements befestigt werden können.

Figur 6 enthält ein oberes Schaubild, in welchem Reflexionsspektren für die Winkel 0°, 20° und 40° skizziert sind (vgl. Kurven I bis III, Abszisse: Wellenlänge λ, Ordinate: Reflexionsgrad R), und ein unteres Schaubild mit dem Spektrum (Abszisse: Wellenlänge λ, Ordinate: Intensität I) der in der aktiven Schichtenfolge erzeugten Strahlung. Diese Schaubilder haben sowohl für das in Figur 4 als auch für das in Figur 5 dargestellte Bauelement Gültigkeit.

Wie aus den beiden Schaubildern hervorgeht, befindet sich die spektrale Verteilung der erzeugten Strahlung am kurzwelligen Rand der Reflexionsspektren des Filterelements. Somit liegen Lichtstrahlen, die mit der Oberflächennormalen des Filterelements einen Winkel kleiner oder gleich 40° einschließen, innerhalb eines Passbands des Filterelements. Diese Lichtstrahlen werden vom Filterelement im Wesentlichen transmittiert, während Lichtstrahlen, die mit der Oberflächennormalen des Filterelements einen Winkel größer als 40° einschließen, im Wesentlichen reflektiert werden.

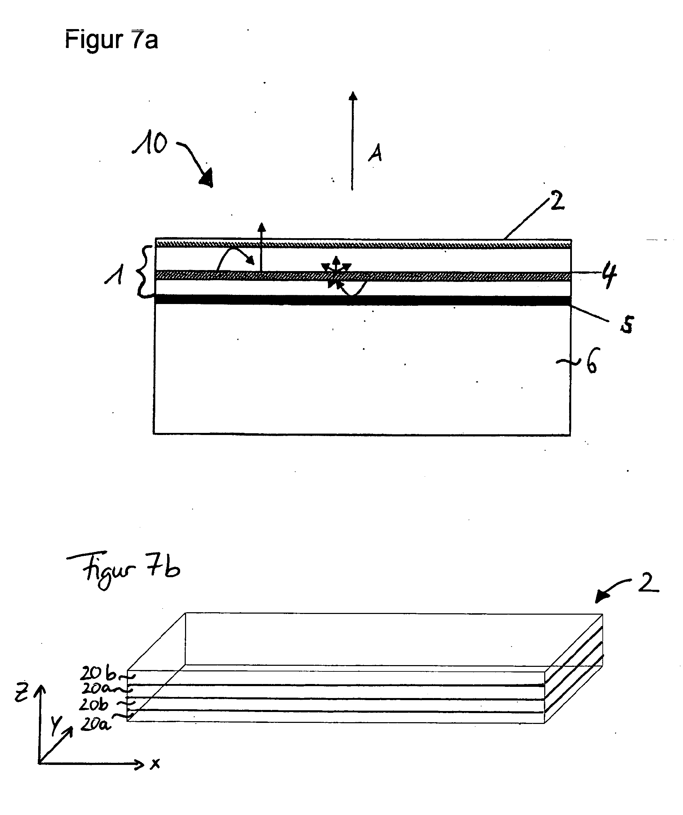

Das in Figur 7a dargestellte strahlungsemittierende Bauelement 10 weist ein Trägersubstrat 6 und einen auf diesem angeordneten Schichtenstapel 1 auf. Auf einer Strahlungsaustrittsseite des Bauelements 10 wird der Schichtenstapel 1 durch das Filterelement 2 begrenzt. Das Filterelement 2 ist in diesem Ausführungsbeispiel ein Polarisationsfilter.

Das Filterelement 2 lässt Licht mit einer Polarisationsrichtung durch, alles andere Licht wird in den Schichtenstapel 1 zurückreflektiert. Das zurückreflektierte Licht kann teilweise in der aktiven Schichtenfolge 4 absorbiert und, entsprechend der internen Quanteneffizienz, wieder mit einer neuen Polarisationsrichtung emittiert werden. Nicht absorbiertes Licht kann an einer zwischen dem Schichtenstapel 1 und dem Trägersubstrat 6 angeordneten Reflexionsschicht 5 reflektiert werden. Besonders vorteilhaft hierfür ist eine Dünnfilm-LED mit einem integrierten Metallspiegel als Reflexionsschicht 5. Das reflektierte Licht läuft wieder durch die aktive Schichtenfolge 4, wo es entweder absorbiert und gegebenenfalls reemittiert wird oder wieder auf das Filterelement 2 trifft.

In Figur 7b ist ein als Polarisationsfilter geeignetes Filterelement 2 perspektivisch dargestellt. Das Filterelement 2 umfasst mehrere doppelbrechende Schichten 20a und 20b. Die Schichten 20a weisen in x-Richtung einen ersten Brechungsindex n1 und in y-Richtung einen zweiten Brechungsindex n auf. Die Schichten 20b weisen in x-Richtung einen dritten Brechungsindex n2 und in y-Richtung den zweiten Brechungsindex n auf. Somit alterniert der Brechungsindex in der x-Richtung über die Schichten 20a und 20b hinweg, während er in der y-Richtung konstant bleibt. Lichtstrahlen, deren Polarisationsrichtung parallel zur x-Richtung ist, können daher am Übergang zwischen den verschiedenen Schichten 20a und 20b reflektiert und in den Schichtenstapel zurückgeschickt werden. Insbesondere weisen die Schichten 20a und 20b eine optische Dicke von λ/4 auf. Ferner interferieren die Lichstrahlen mit der Polarisationsrichtung parallel zur x-Richtung vorzugsweise in Transmissionsrichtung destruktiv und in Reflexionsrichtung konstruktiv. Lichtstrahlen, deren Polarisationsrichtung parallel zur y-Richtung ist, durchlaufen ein Medium, das optisch homogen ist, und passieren das Filterelement daher im Wesentlichen ohne Ablenkung. Somit emittiert das strahlungsemittierende Bauelement 10 Strahlung mit einer Polarisationsrichtung parallel zur y-Richtung.

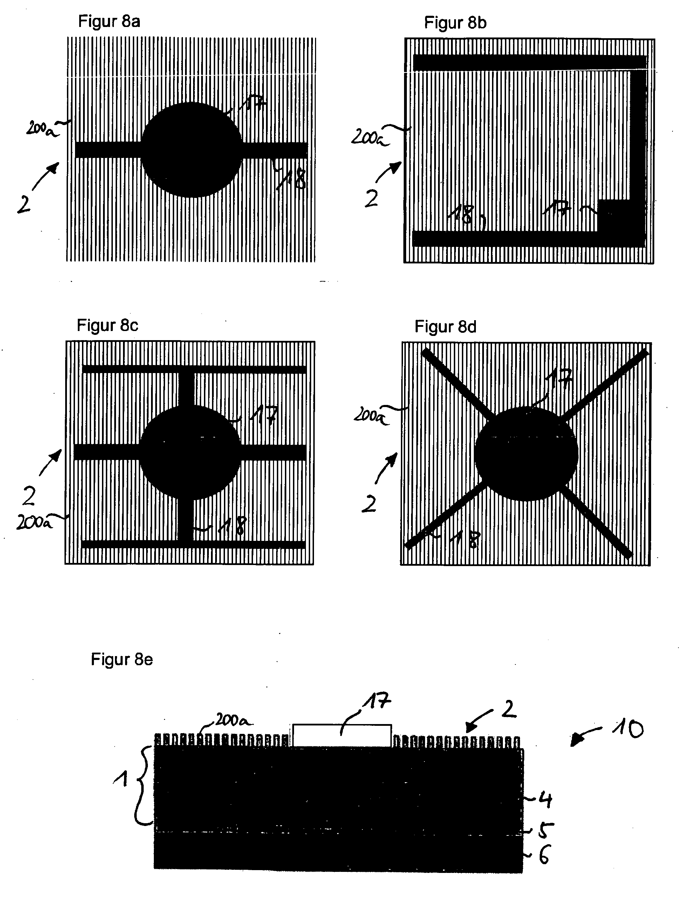

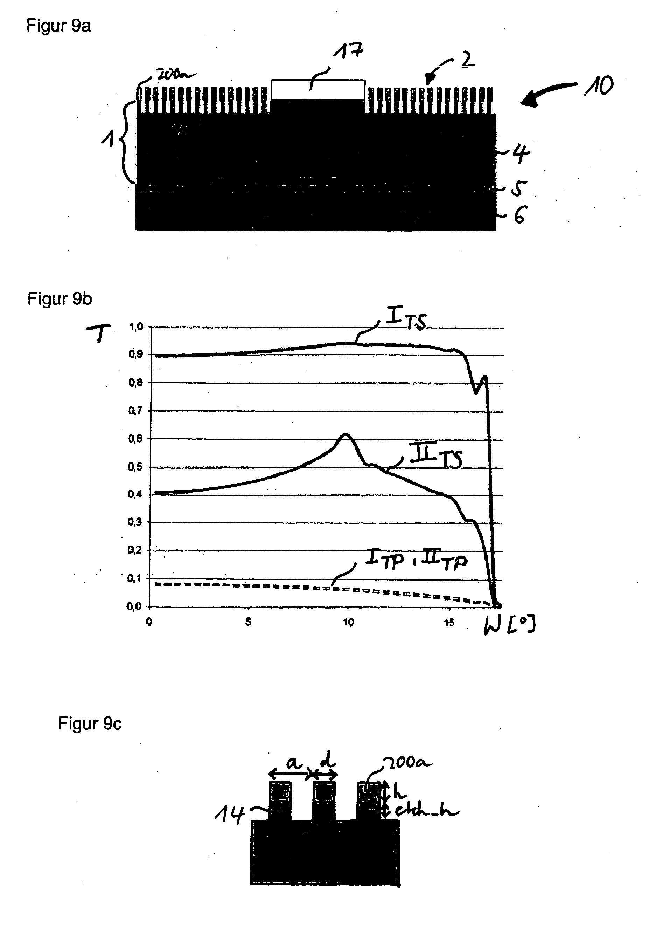

Weitere Möglichkeiten zur Ausgestaltung des Filterelements als Polarisationsfilter werden nachfolgend anhand der Figuren 8a bis 8e und 9a bis 9c beschrieben. Allen diesen Ausführungsbeispielen ist gemein, dass der Polarisationsfilter als Metallgitter ausgebildet ist. Insbesondere besteht das Metallgitter aus parallel zu einer Kante des Schichtenstapels verlaufenden Metallstreifen 200a.

Die Metallstreifen 200a folgen vorzugsweise in einem Abstand aufeinander, der kleiner ist als die Wellenlänge der Strahlung. Die Breite der Metallstreifen 200a beträgt einen Bruchteil des Abstands. Für das Metallgitter können Metalle oder Metallverbindungen, insbesondere Au, Ag, Al oder AuZn, verwendet werden. Lichtstrahlen mit einer Polarisationsrichtung parallel zu den Metallstreifen 200a werden reflektiert, während Lichtstrahlen mit einer Polarisationsrichtung senkrecht zu den Metallstreifen 200a transmittiert werden.

Neben der Funktion als Polarisationsfilter kann das Metallgitter vorteilhafterweise als Kontaktgitter dienen und eine homogene Stromeinprägung in den Schichtenstapel gewährleisten. Das Metallgitter kann hierfür mittels Kontaktarmen 18 mit einem Bondpad 17 verbunden sein. Die Kontaktarme 18 sind typischerweise breiter als die Metallstreifen 200a. Vorteilhafterweise können mittels der Verwendung des Metallgitters zur Stromeinprägung weitere Kontaktarme eingespart werden, so dass die effektive Emissionsfläche vergrößert ist.

Wie aus den Figuren 8a, 8c und 8d hervorgeht, in welchen jeweils eine Aufsicht des Bauelements gezeigt ist, kann das Bondpad 17 zentral auf der Emissionsfläche des Bauelements angeordnet sein. Die Kontaktarme 18 führen vom Bondpad 17 nach außen zu den Kanten des Bauelements und versorgen so die dezentralen Bereiche mit Strom. Alternativ kann das Bondpad 17, wie in Figur 8b dargestellt ist, in einer Ecke des Chips angeordnet sein. Dies hat den Vorteil, dass in der Chipmitte Strahlung emittiert werden kann.

Figur 8e zeigt einen Querschnitt des Bauelements gemäß den Figuren 8a und 8d. Das Bauelement 10 ist in Dünnfilmtechnik hergestellt, das heißt der Schichtenstapel 1 ist vom Aufwachssubstrat abgelöst. Der Schichtenstapel 1 ist stattdessen auf einem Trägersubstrat 6 angeordnet und rückseitig mit einer Reflexionsschicht 5 versehen. Der Strahlungsanteil, der vom Filterelement 2 zurückreflektiert wird kann mittels der Reflexionsschicht 5 in Richtung der Auskoppelseite umgelenkt werden. Um die auftreffenden Lichtstrahlen mit einer neuen Polarisationsrichtung zu versehen und so die Auskoppelwahrscheinlichkeit zu erhöhen, kann die Reflexionsschicht 5 beispielsweise Unebenheiten aufweisen. Alternativ kann der Schichtenstapel 1 rückseitig aufgeraut sein, wobei die Unebenheiten mittels einer Planarisierungsschicht (nicht dargestellt) zwischen dem Schichtenstapel 1 und der Reflexionsschicht 5 ausgeglichen werden können. Die Planarisierungsschicht enthält vorzugsweise ein strahlungsduchlässiges Material, beispielsweise ein TCO.

Eine weitere Variante ist in Figur 9a dargestellt. Der Schichtenstapel 1 ist auf der Vorderseite strukturiert, so dass das Bauelement 10 im Gegensatz zu dem in Figur 8e dargestellten Bauelement nicht auf der Rückseite, sondern auf der Vorderseite einen internen Streumechanismus aufweist. Die Strukturierung ist dem Metallgitter entsprechend gestaltet, so dass die Metallstreifen 200a des Metallgitters auf Erhebungen 14 verlaufen. Bei dieser Variante kann auf eine Planarisierungsschicht verzichtet werden. Ferner kann die Reflexionsschicht 5 eben ausgebildet werden, so dass eine vergleichsweise gute Reflexionswirkung erzielbar ist.

In Figur 9b sind simulierte Transmissionsspektren für ein Bauelement gemäß Figur 9a (vgl. Kurve I_{TS}, I_{TP}) und ein Bauelement mit unstrukturierter Oberfläche, wobei die Metallstreifen 200a nicht auf Erhebungen verlaufen, dargestellt (vgl. Kurve II_{TS}, II_{TP}).

"TS" steht für die Polarisationsrichtung senkrecht zu den Metallstreifen 200a. "TP" steht für die Polarisationsrichtung parallel zu den Metallstreifen 200a.

Die Ordinate gibt den Transmissionsgrad T an. Die Abszisse gibt den Winkel W zwischen der Oberflächennormalen des Filterelements und dem einfallenden Lichtstrahl an.
Wie dem Schaubild der Figur 9b zu entnehmen ist, macht es im Falle der parallel polarisierten Strahlung keinen Unterschied, ob die Oberfläche strukturiert oder unstrukturiert ist. In beiden Fällen wird die Strahlung mit hoher Wahrscheinlichkeit reflektiert. Jedoch kann im Falle der senkrecht polarisierten Strahlung der Transmissionsgrad T maßgeblich erhöht werden, wenn die Oberfläche mit einer Strukturierung versehen wird.

In Figur 9c sind die Erhebungen 14 mit den aufgebrachten Metallstreifen 200a vergrößert dargestellt. Die Metallstreifen 200a weisen ebenso wie die Erhebungen 14 die Breite d auf. Der Abstand zwischen den Metallstreifen 200a ebenso wie zwischen den Erhebungen 14 ist mit a-d angegeben. Die Höhe der Metallstreifen 200a ist mit h und die Höhe der Erhebungen 14 mit etch_h bezeichnet.

Zur Simulation der Transmissionsspektren wurden folgende Werte verwendet: a = 160 nm, h = 80 nm, d = 80 nm und etch_h = 180 nm.

Zur Herstellung des Metallgitters gemäß den beschriebenen Varianten kommen zwei verschiedene Methoden in Frage: entweder wird das Metallgitter durch eine auf dem Schichtenstapel angeordnete Maske strukturiert aufgebracht, oder nachfolgend durch Strukturierung einer durchgehenden Metallschicht erzeugt. Beispielsweise kann die Strukturierung mittels lithographischer Methoden (Elektronenstrahl- oder Nanoimprintlithographie) erfolgen. Das Metallgitter wird insbesondere durch Aufsputtern oder Aufdampfen hergestellt.

Für alle hier beschriebenen Filterelemente gilt, dass entweder die Dicke des Filterelements klein gegenüber der lateralen Ausdehnung des Bauelements ist oder die Seitenflanken des Filterelements verspiegelt sind, so dass die erzeugte Strahlung effizient genutzt werden kann.

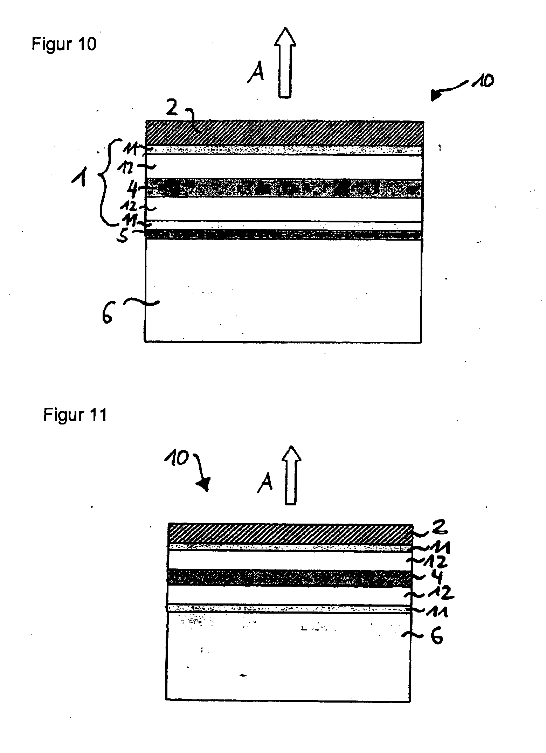

Die Figuren 10 bis 15 sollen verschiedene Anordnungsmöglichkeiten für die Reflexionsschicht 5, die Streuschicht 11 und das Filterelement 2 illustrieren. Es versteht sich, dass das Filterelement 2 hierbei als Raumwinkelfilter oder Polarisationsfilter gemäß einer der oben beschriebenen Varianten ausgebildet sein kann.

Das in Figur 10 dargestellte strahlungsemittierende Bauelement 10 weist ein Trägersubstrat 6 auf, welchem in Abstrahlrichtung A eine Reflexionsschicht 5, eine erste Streuschicht 11, eine dotierte Schicht 12, beispielsweise eine Confinementschicht, eine aktive Schichtenfolge 4, eine weitere dotierte Schicht 12, beispielsweise eine Confinementschicht, eine zweite Streuschicht 11 und ein Filterelement 2 nachgeordnet sind. Vorzugsweise gehören die erste Streuschicht 11, die dotierte Schicht 12, die aktive Schichtenfolge 4, die weitere dotierte Schicht 12 und die zweite Streuschicht 11 zum Schichtenstapel 1 und enthalten ein Halbleitermaterial.

Das in Figur 11 dargestellte strahlungsemittierende Bauelement 10 weist bis auf die Reflexionsschicht 5 dem in Figur 10 dargestellten strahlungsemittierenden Bauelement 10 entsprechende Schichten auf. Das Trägersubstrat 6 hat bei diesem Ausführungsbeispiel einen von den darüber liegenden Schichten deutlich verschiedenen Brechungsindex. Insbesondere ist der Brechungsindex kleiner, so dass auftreffende Strahlung totalreflektiert werden kann. Somit kann auf eine Reflexionsschicht verzichtet werden.

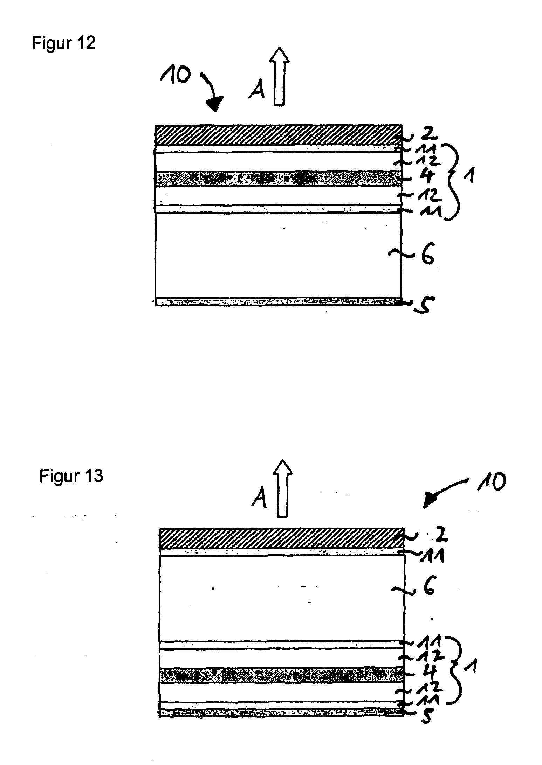

Der Aufbau des in Figur 12 gezeigten strahlungsemittierenden Bauelements 10 entspricht weitgehend dem in Figur 10. Unterschiedlich ist das Trägersubstrat 6, das transparent ist und beispielsweise Saphir enthält. Auf einer dem Schichtenstapel 1 abgewandten Seite des Trägersubstrats 6 ist eine Reflexionsschicht 5 angeordnet. Die Strahlung, die durch das Trägersubstrat 6 transmittiert wird, kann also mittels der Reflexionsschicht 5 in den Schichtenstapel 1 zurückreflektiert werden.

In Figur 13 ist ein strahlungsemittierendes Bauelement 10 mit einer Flip-Chip-Anordnung dargestellt. Auf einer dem Trägersubstrat 6 abgewandten Seite des Schichtenstapels 1 ist eine Reflexionsschicht 5 angeordnet. Ferner sind auf einer dem Schichtenstapel 1 abgewandten Seite des Trägersubstrats 6 eine Streuschicht 11 und das Filterelement 2 angeordnet. Das Trägersubstrat 6 ist hierbei vorzugsweise für die von der aktiven Schichtenfolge 4 erzeugte Strahlung durchlässig. Beispielsweise enthält das Trägersubstrat 6 Saphir. Vorteil bei dieser Anordnung ist, dass das Aufwachssubstrat, das zugleich das Trägersubstrat 6 ist, nicht vom Schichtenstapel 1 abgelöst werden muss. Trotzdem kann die im Betrieb entstehende Wärme aufgrund der Flip-Chip-Anordnung dort abgegriffen werden, wo sie entsteht, nämlich nahe der aktiven Schichtenfolge 4. Mittels der Reflexionsschicht 5 ist eine gute Wärmeabfuhr möglich.

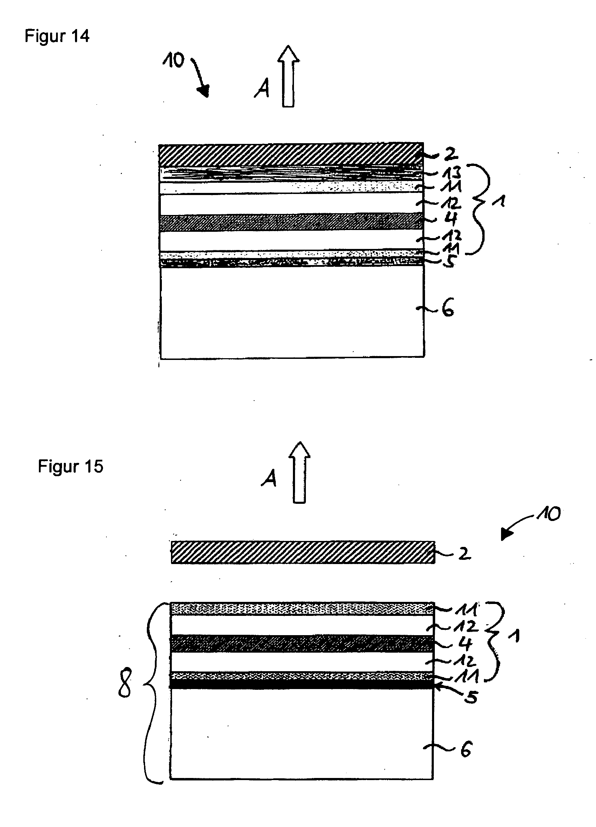

Das in Figur 14 dargestellte strahlungsemittierende Bauelement 10 weist ein Trägersubstrat 6 auf, welchem in Abstrahlrichtung A eine Reflexionsschicht 5, eine erste Streuschicht 11, eine dotierte Schicht, beispielsweise eine Confinementschicht, eine aktive Schichtenfolge 4 zur Erzeugung von elektromagnetischer Strahlung, eine weitere dotierte Schicht 12, beispielsweise eine Confinementschicht, eine zweite Streuschicht 11, eine Planarisierungsschicht 13 und ein Filterelement 2 nachgeordnet sind. Die Streuschichten 11 sind fakultative Bestandteile. Dies gilt auch für die Planarisierungsschicht 13, die insbesondere dann entfallen kann, wenn die darunter liegende Schicht plan ist.

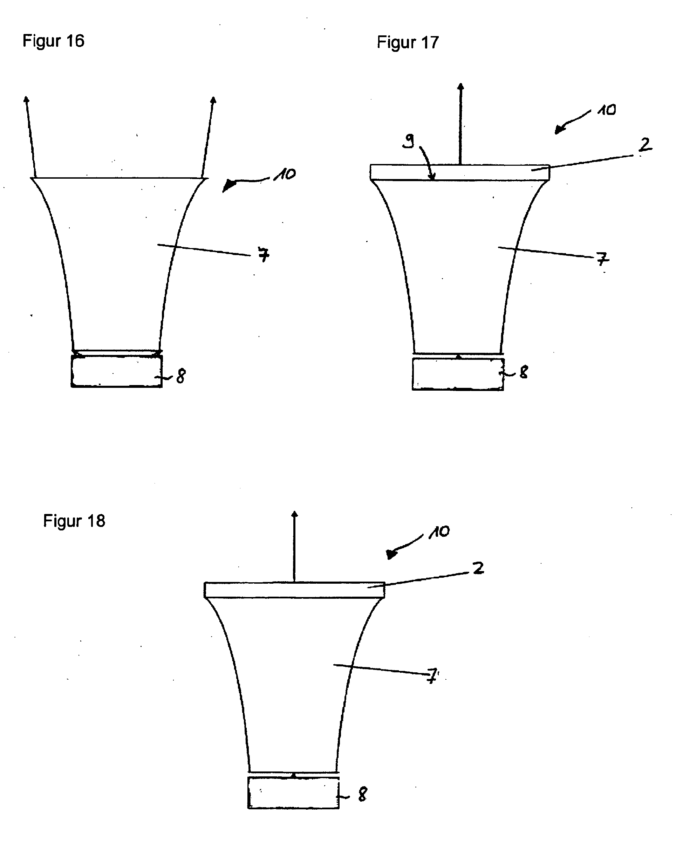

Das in Figur 15 dargestellte Filterelement 2 ist als separates externes Element oberhalb des Halbleiterchips 8 beziehungsweise Schichtenstapels 1 angebracht. Es ist denkbar, dass in Abstrahlrichtung A vor dem Filterelement 2 optische Elemente angeordnet sind (vgl. Figuren 17 bis 20).

Es sei darauf hingewiesen, dass die im Zusammenhang mit den Figuren 10 bis 15 dargestellten Streuschichten 11 keine notwendigen, sondern fakultative Bestandteile sind

In Figur 16 ist ein strahlungsemittierendes Bauelement 10 dargestellt, das einen Dünnfilm-Halbleiterchip 8 und ein optisches Element 7 aufweist, das als Filterelement dient. Das optische Element 7 ist in diesem Fall ein verspiegelter Konzentrator, der chipnah angeordnet ist. Um die Verluste klein zu halten, sollte der Abstand zwischen einer Strahlungseintrittsfläche des optischen Elements 7 und der Chipoberfläche kleiner als 10 % der Chip-Kantenlänge sein sowie der Akzeptanzwinkel des optischen Elements 7 möglichst nahe bei +/- 90° liegen. Ferner könnte es sinnvoll sein, die Seitenflächen der Dünnfilm-Halbleiterchip 8 zu verspiegeln.

Das in Figur 17 dargestellte strahlungsemittierende Bauelement 10 weist einen Dünnfilm-Halbleiterchip 8 und ein optisches Element 7 zur Erhöhung der Leuchtdichte auf. Das optische Element 7 ist chipnah angeordnet und vorzugsweise als verspiegelter Konzentrator ausgebildet. Ferner weist das strahlungsemittierende Bauelement 10 ein Filterelement 2 auf, welches insbesondere eine lichtrichtende Folie, beispielsweise eine BEF, ist. Das Filterelement 2 ist auf einer Strahlungsdurchtrittsfläche 9 des optischen Elements 7 aufgebracht. Bei diesem Ausführungsbeispiel ist das Filterelement 2 auf einer dem Dünnfilm-Halbleiterchip 8 abgewandten Seite des optischen Elements 7 angeordnet.

In Figur 18 ist ein strahlungsemittierendes Bauelement 10 dargestellt, das einen Dünnfilm-Halbleiterchip 8 mit chipnahem optischem Element 7, insbesondere einem verspiegelten Konzentrator, und ein Filterelement 2 aufweist, das als Polarisationsfilter zur Erzeugung von polarisiertem Licht ausgebildet ist. Vorteil bei einem derartigen Aufbau ist, dass der Polarisationsfilter, dessen Wirkung richtungsabhängig ist, mittels des Konzentrators effizienter genutzt werden kann, da der Konzentrator die Lichtstrahlen bereits in geeigneter Weise ausrichtet.

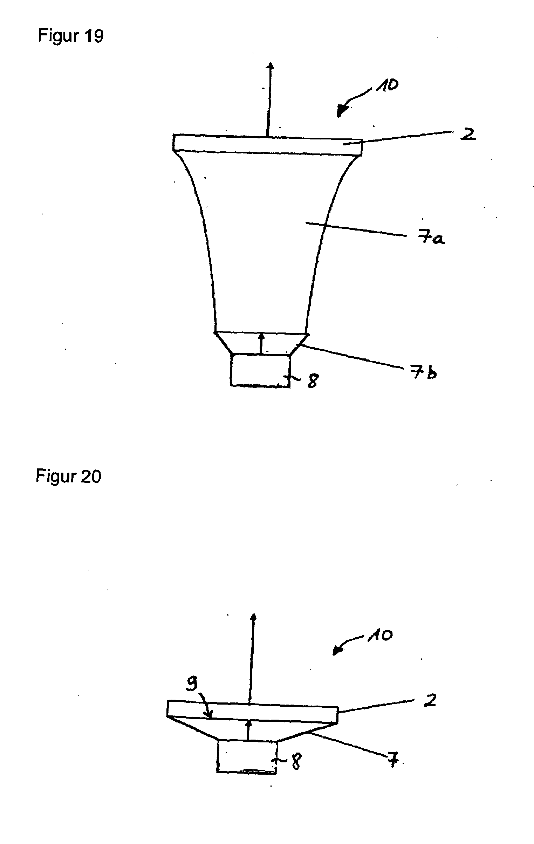

Das in Figur 19 dargestellte strahlungsemittierende Bauelement 10 weist eine den Figuren 17 und 18 entsprechende Anordnung auf, wobei das Bauelement 10 ein weiteres optisches Element 7b aufweist, das als Reflektor ausgebildet ist. Das weitere optische Element 7b ist unterhalb der Einkoppelfläche des als Konzentrator ausgebildeten optischen Elements 7a angeordnet.

In Figur 20 ist ein strahlungsemittierendes Bauelement 10 dargestellt, das eine Anordnung entsprechend der Figuren 17 bis 20 aufweist, wobei das optische Element 7 nicht als Konzentrator, sondern als Reflektor ausgebildet ist, an dessen Strahlungsdurchtrittsfläche 9 das Filterelement 2 angebracht ist. Das Filterelement 2 ist reflektierend für den nicht-transmittierten Strahlungsanteil. Beispielsweise kann das Filterelement 2 eine licht-richtende Folie oder eine Polarisationsfolie sein.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Patentanmeldung beansprucht die Priorität der deutschen Patentanmeldung 102006037736.2, deren Offenbarungsgehalt hiermit durch Rückbezug aufgenommen wird.

## Patentansprüche

1. Strahlungsemittierendes Bauelement (10) mit einem auf einem Halbleitermaterial basierenden Schichtenstapel (1), der eine aktive Schichtenfolge (4) zur Erzeugung von elektromagnetischer Strahlung aufweist, und einem der aktiven Schichtenfolge (4) in Abstrahlrichtung (A) nachgeordneten Filterelement (2), mittels welchem ein erster Strahlungsanteil transmittiert wird, und ein zweiter Strahlungsanteil in den Schichtenstapel (1) reflektiert wird, wobei
der zweite Strahlungsanteil nach der Reflexion an dem Filterelement (2) einem Ablenkprozess oder einem Absorptions-und Emissionsprozess unterliegt und die abgelenkte oder emittierte Strahlung erneut auf das Filterelement (2) auftrifft.

2. Strahlungsemittierendes Bauelement (10) nach Anspruch 1, wobei
sich der erste Strahlungsanteil aus Lichtstrahlen zusammensetzt, die beim Auftreffen auf das Filterelement (2) innerhalb eines ersten Raumwinkelbereichs liegen, während sich der zweite Strahlungsanteil aus Lichtstrahlen zusammensetzt, die beim Auftreffen auf das Filterelement (2) innerhalb eines zweiten vom ersten Raumwinkelbereich verschiedenen Raumwinkelbereich liegen.

3. Strahlungsemittierendes Bauelement (10) nach Anspruch 2, wobei
das Filterelement (2) ein Raumwinkelfilter ist.

4. Strahlungsemittierendes Bauelement (10) nach Anspruch 3, wobei
das Filterelement (2) mindestens eine ebene Schicht aufweist, die ein strahlungsdurchlässiges Material enthält.

5. Strahlungsemittierendes Bauelement (10) nach Anspruch 4, wobei
die mindestens eine ebene Schicht ein Material mit einem Brechungsindex enthält, der kleiner ist als der Brechungsindex des Halbleitermaterials des Schichtenstapels (1).

6. Strahlungsemittierendes Bauelement (10) nach Anspruch 4 oder 5, wobei
die mindestens eine Schicht ein Siliziumoxid, Siliziumnitrid, Siliziumoxinitrid, Aluminiumoxid, Titanoxid, Tantaloxid, ein Glasmaterial oder ein TCO enthält.

7. Strahlungsemittierendes Bauelement (10) nach einem der Ansprüche 1 bis 3, wobei
das Filterelement (2) ein dielektrischer Bandpassfilter ist.

8. Strahlungsemittierendes Bauelement (10) nach Anspruch 7, wobei
der Bandpassfilter mindestens zwei dielektrische Schichten mit unterschiedlichem Brechungsindex aufweist.

9. Strahlungsemittierendes Bauelement (10) nach Anspruch 7 oder 8, wobei
der Bandpassfilter eine erste Schicht aufweist, die Titannitrid enthält, und eine zweite Schicht aufweist, die Siliziumoxid oder Titanoxid enthält.

10. Strahlungsemittierendes Bauelement (10) nach einem der Ansprüche 1 bis 5, wobei
das Filterelement (2) Strukturelemente (2a) aufweist.

11. Strahlungsemittierendes Bauelement (10) nach Anspruch 10, wobei
die Strukturelemente (2a) in Abstrahlrichtung (A) schmaler werden.

12. Strahlungsemittierendes Bauelement (10) nach Anspruch 10, wobei
die Strukturelemente (2a) in Abstrahlrichtung (A) breiter werden.

13. Strahlungsemittierendes Bauelement (10) nach einem der Ansprüche 10 bis 12, wobei
die Strukturelemente (2a) kegelartig, pyramidenartig oder prismenartig ausgebildet sind.

14. Strahlungsemittierendes Bauelement (10) nach einem der Ansprüche 10 bis 13, wobei
die Strukturelemente (2a) entsprechend einem zweidimensionalen Gitter angeordnet sind.

15. Strahlungsemittierendes Bauelement (10) nach einem der Ansprüche 10 bis 14, wobei
die Strukturelemente (2a) durch Strukturierung des Schichtenstapels (1) gebildet sind.

16. Strahlungsemittierendes Bauelement (10) nach einem der Ansprüche 10 bis 14, wobei
eine vom Schichtenstapel (1) verschiedene Schicht (2_{II}) die Strukturelemente (2a) aufweist.

17. Strahlungsemittierendes Bauelement (10) nach Anspruch 16, wobei
die Schicht (2_{II}) mit den Strukturelementen (2a) ein strahlungsdurchlässiges Material enthält.

18. Strahlungsemittierendes Bauelement (10) nach Anspruch 16 oder 17, wobei
die Schicht (2_{II}) mit den Strukturelementen (2a) mindestens eines der folgenden Materialien enthält: Siliziumoxid, Siliziumnitrid, Siliziumoxinitrid, Aluminiumoxid, Titanoxid, Tantaloxid, Glas, TCO, PMMA, Photolack, Epoxidharz, Silikon.

19. Strahlungsemittierendes Bauelement (10) nach einem der Ansprüche 1 bis 3, wobei
das Filterelement (2) ein photonischer Kristall ist.

20. Strahlungsemittierendes Bauelement (10) nach Anspruch 1, wobei
das Filterelement (2) ein Polarisationsfilter ist.

21. Strahlungsemittierendes Bauelement (10) nach Anspruch 20, wobei der erste Strahlungsanteil nach dem Auftreffen auf das Filterelement (2) linear polarisierte Lichtstrahlen einer ersten Polarisationsrichtung und der zweite Strahlungsanteil nach dem Auftreffen auf das Filterelement (2) senkrecht zur ersten Polarisationsrichtung linear polarisierte Lichtstrahlen aufweisen.

22. Strahlungsemittierendes Bauelement (10) nach Anspruch 20 oder 21, wobei
das Filterelement (2) mindestens ein doppelbrechendes Material enthält.

23. Strahlungsemittierendes Bauelement (10) nach Anspruch 22, wobei
das Filterelement (2) mindestens eine erste doppelbrechende Schicht (2a) mit einem ersten Brechungsindex n1 und einem zweiten Brechungsindex n und mindestens eine zweite doppelbrechende Schicht (2b) mit einem dritten Brechungsindex n2 und dem zweiten Brechungsindex n auf aufweist.

24. Strahlungsemittierendes Bauelement (10) nach Anspruch 23, wobei
die zweite Schicht (2b) der ersten Schicht (2a) in Abstrahlrichtung (A) nachgeordnet ist.

25. Strahlungsemittierendes Bauelement (10) nach Anspruch 23 oder 24, wobei
die erste und zweite Schicht (2a, 2b) eine optische Dicke von λ/4 aufweisen.

26. Strahlungsemittierendes Bauelement (10) nach Anspruch 20 oder 21, wobei
das Filterelement (2) ein Metallgitter aufweist.

27. Strahlungsemittierendes Bauelement (10) nach Anspruch 26, wobei
das Metallgitter Metallstreifen (200a) aufweist, die parallel zu einer Kante des Schichtenstapels (1) verlaufen.

28. Strahlungsemittierendes Bauelement (10) nach Anspruch 27, wobei
der Schichtenstapel (1) derart strukturiert ist, dass die Metallstreifen (200a) auf Erhebungen (14) des Schichtenstapels (1) verlaufen.

29. Strahlungsemittierendes Bauelement (10) nach Anspruch 20 oder 21, wobei
das Filterelement (2) ein photonischer Kristall ist.

30. Strahlungsemittierendes Bauelement (10) nach einem der vorhergehenden Ansprüche, wobei
auf einer dem Filterelement (2) gegenüber liegenden Seite der aktiven Schichtenfolge (4) eine Reflexionsschicht (5) angeordnet ist.

31. Strahlungsemittierendes Bauelement (10) nach Anspruch 30, wobei
die Reflexionsschicht (5) ein Metall enthält.

32. Strahlungsemittierendes Bauelement (10) nach Anspruch 30 oder 31, wobei
die Reflexionsschicht (5) auf einem Trägersubstrat (6) angeordnet ist.

33. Strahlungsemittierendes Bauelement (10) nach einem der vorhergehenden Ansprüche, wobei
der Schichtenstapel (1) ein Dünnfilm-Halbleiterkörper ist.

34. Strahlungsemittierendes Bauelement (10) nach einem der Ansprüche 30 bis 33, wobei
zwischen der aktiven Schichtenfolge (4) und der Reflexionsschicht (5) eine Streuschicht (11) angeordnet ist.

35. Strahlungsemittierendes Bauelement (10) nach einem der vorhergehenden Ansprüche, das
ein dem Schichtenstapel (1) in Abstrahlrichtung (A) nachgeordnetes optisches Element (7) aufweist, wobei
das Filterelement (2) auf einer Strahlungsdurchtrittsfläche (9) des optischen Elements (7) angeordnet ist.

36. Strahlungsemittierendes Bauelement (10) nach Anspruch 35, wobei
das optische Element (7) ein Reflektor und/oder Konzentrator ist.
